# EUROPÄISCHE PATENTSCHRIFT

(11) **EP 2 338 182 B1**
(45) Veröffentlichungstag und Bekanntmachung des Hinweises auf die Patenterteilung: **07.11.2018**
(21) Anmeldenummer: 09748013.1
(22) Anmeldetag: 16.09.2009
(51) Int. Cl.: H01L 33/40

(54) **OPTOELEKTRONISCHES HALBLEITERBAUELEMENT**
OPTOELECTRONIC SEMICONDUCTOR COMPONENT
COMPOSANT OPTOÉLECTRONIQUE À SEMI-CONDUCTEUR

(30) Priorität: 21.10.2008 DE 102008052405
(43) Veröffentlichungstag der Anmeldung: 29.06.2011
(73) Patentinhaber: OSRAM Opto Semiconductors GmbH, 93055 Regensburg (DE)
(72) Erfinder: STRASSBURG, Martin, 93105 Tegernheim (DE); HÖPPEL, Lutz, 93087 Alteglofsheim (DE); PETER, Matthias, 93087 Alteglofsheim (DE); ZEHNDER, Ulrich, 93191 Rettenbach (DE); TAKI, Tetsuya, 93049 Regensburg (DE); LEBER, Andreas, 93049 Regensburg (DE); BUTENDEICH, Rainer, 93059 Regensburg (DE); BAUER, Thomas, 93047 Regensburg (DE)
(74) Vertreter: Epping - Hermann - Fischer
(86) Internationale Anmeldenummer: PCT/DE2009/001322
(87) Internationale Veröffentlichungsnummer: WO 2010/045907

(56) Entgegenhaltungen:
- US-A1- 2006 049 417
- US-A1- 2008 111 144
- FICHTENBAUM N ET AL: "Electrical characterization of p-type N-polar and Ga-polar GaN grown by metalorganic chemical vapor deposition" APPLIED PHYSICS LETTERS, AIP, AMERICAN INSTITUTE OF PHYSICS, MELVILLE, NY, US, Bd. 91, Nr. 17, 23. Oktober 2007 (2007-10-23), Seiten 172105-172105, XP012099824 ISSN: 0003-6951
- JONES K M ET AL: "Investigation of inversion domains in GaN by electric-force microscopy" APPLIED PHYSICS LETTERS, AIP, AMERICAN INSTITUTE OF PHYSICS, MELVILLE, NY, US, Bd. 78, Nr. 17, 23. April 2001 (2001-04-23), Seiten 2497-2499, XP012027818 ISSN: 0003-6951
- TAVERNIER P R ET AL: "The growth of N-face GaN by MOCVD: effect of Mg, Si, and In" JOURNAL OF CRYSTAL GROWTH, ELSEVIER, AMSTERDAM, NL, Bd. 264, Nr. 1-3, 15. März 2004 (2004-03-15), Seiten 150-158, XP004493916 ISSN: 0022-0248
- STUTZMANN M ET AL: "Playing with Polarity" PHYSICA STATUS SOLIDI. B, BASIC RESEARCH, AKADEMIE VERLAG, BERLIN, DE, Bd. 228, Nr. 2, 1. November 2001 (2001-11-01), Seiten 505-512, XP002542297 ISSN: 0370-1972
- FICHTENBAUM ET AL: "Impurity incorporation in heteroepitaxial N-face and Ga-face GaN films grown by metalorganic chemical vapor deposition" JOURNAL OF CRYSTAL GROWTH, ELSEVIER, AMSTERDAM, NL, Bd. 310, Nr. 6, 31. Dezember 2007 (2007-12-31), Seiten 1124-1131, XP022499545 ISSN: 0022-0248
- GESSMANN TH ET AL: "Ohmic contact technology in III nitrides using polarization effects of cap layers" JOURNAL OF APPLIED PHYSICS, AMERICAN INSTITUTE OF PHYSICS. NEW YORK, US, Bd. 92, Nr. 7, 1. Oktober 2002 (2002-10-01), Seiten 3740-3744, XP012057339 ISSN: 0021-8979

## Beschreibung

Die Erfindung betrifft ein optoelektronisches Halbleiterbauelement, insbesondere ein auf einem Nitridverbindungshalbleiter basierendes Bauelement, wie beispielsweise eine LED- oder eine Laserdiode.

Diese Patentanmeldung beansprucht die Priorität der deutschen Patentanmeldung 10 2008 052 405.0. Ein optoelektronisches Halbleiterbauelement weist in der Regel einen n-dotierten Bereich, einen p-dotierten Bereich und eine dazwischen angeordnete strahlungsemittierende oder strahlungsempfangende aktive Zone auf. Zur Herstellung eines elektrischen Anschlusses werden der p-dotierte Bereich und der n-dotierte Bereich zumindest in einem Teilbereich mit einer Anschlussschicht versehen. Bei der Anschlussschicht kann es sich beispielsweise um eine Metallschicht oder eine Schicht aus einem transparenten leitfähigen Oxid (TCO, transparent conductive oxide) handeln. Bei der Verbindung einer p-dotierten Nitridverbindungshalbleiterschicht mit einer elektrischen Anschlussschicht treten oftmals unerwünscht hohe Spannungsabfälle an der Grenzfläche zwischen dem Halbleitermaterial und der Anschlussschicht auf, durch die die Effizienz des optoelektronischen Bauelements vermindert wird.

US 2006/049417 A1 (LI YUN-LI [TW] ET AL) 9. März 2006 (2006-03-09) offenbart ein optoelektronisches Halbleiterbauelement mit einer auf einem Nitridverbindungshalbleiter basierenden Halbleiterschichtenfolge, die einen n-dotierten Bereich, einen p-dotierten Bereich und eine zwischen dem n-dotierten Bereich und dem p-dotierten Bereich angeordnete aktive Zone enthält. Eine p-Kontaktschicht aus p-GaN grenzt an eine Anschlussschicht an, die aus einem Metall oder einem transparenten leitfähigen Oxid besteht. Inseln aus InGaN werden auf der Grenzfläche der p-Kontaktschicht zur Anschlussschicht aufgewachsen.

US 2008/111144 A1 (FICHTENBAUM NICHOLAS A [US] ET AL) 15. Mai 2008 (2008-05-15) offenbart ein optoelektronisches Halbleiterbauelement mit einer auf einem Nitridverbindungshalbleiter basierenden Halbleiterschichtenfolge, die einen n-dotierten Bereich, einen p-dotierten Bereich und eine zwischen dem n-dotierten Bereich und dem p-dotierten Bereich angeordnete aktive Zone enthält. Eine p-Kontaktschicht aus p-GaN grenzt an eine Anschlussschicht aus Metall. Die p-Kontaktschicht weist an der Grenzfläche zur Anschlussschicht Domänen mit einer N-face-Ausrichtung auf.

Der Erfindung liegt die Aufgabe zugrunde, ein verbessertes optoelektronisches Halbleiterbauelement auf der Basis eines Nitridverbindungshalbleiters anzugeben, das sich durch einen verbesserten Anschluss einer p-Kontaktschicht an eine Anschlussschicht auszeichnet. Insbesondere soll beim Betrieb des Bauelements an der Grenzfläche zwischen der p-Kontaktschicht und der Anschlussschicht ein möglichst geringer Spannungsabfall auftreten.

Diese Aufgabe wird durch ein optoelektronisches Halbleiterbauelement mit den Merkmalen des Patentanspruchs 1 gelöst. Vorteilhafte Ausgestaltungen und Weiterbildungen der Erfindung sind Gegenstand der abhängigen Ansprüche.

Gemäß einer Ausführungsform weist ein optoelektronisches Halbleiterbauelement eine auf einem Nitridverbindungshalbleiter basierende Halbleiterschichtenfolge auf, die einen n-dotierten Bereich, einen p-dotierten Bereich und eine zwischen dem n-dotierten Bereich und dem p-dotierten Bereich angeordnete aktive Zone enthält. Der n-dotierte Bereich und der p-dotierte Bereich müssen nicht notwendigerweise vollständig aus dotierten Schichten gebildet sein, sondern können insbesondere auch undotierte Schichten enthalten.

"Auf einem Nitridverbindungshalbleitern basierend" bedeutet im vorliegenden Zusammenhang, dass die Halbleiterschichtenfolge oder zumindest eine Schicht davon ein III-Nitrid-Verbindungshalbleitermaterial, vorzugsweise InₓAl_{y}Ga_{1-x-y}N umfasst, wobei 0 ≤ x ≤ 1, 0 ≤ y ≤ 1 und x + y ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des InₓAl_{y}Ga_{1-x-y}N-Materials im Wesentlichen nicht ändern. Der Einfachheit halber beinhaltet obige Formel jedoch nur die wesentlichen Bestandteile des Kristallgitters (In, Al, Ga, N), auch wenn diese teilweise durch geringe Mengen weiterer Stoffe ersetzt sein können.

Die aktive Zone kann insbesondere eine strahlungsemittierende oder eine strahlungsempfangende aktive Schicht sein. Die aktive Schicht kann zum Beispiel als pn-Übergang, als Doppelheterostruktur, als Einfach-Quantentopfstruktur oder Mehrfach-Quantentopfstruktur ausgebildet sein. Die Bezeichnung Quantentopfstruktur umfasst dabei jegliche Struktur, bei der Ladungsträger durch Einschluss (Confinement) eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Der p-dotierte Bereich weist eine p-Kontaktschicht aus InₓAl_{y}Ga_{1-x-y}N mit 0 ≤ x ≤ 1, 0 ≤ y ≤ 1 und x + y ≤ 1 auf. Insbesondere kann die p-Kontaktschicht eine GaN-Schicht sein.

Die p-Kontaktschicht grenzt an eine Anschlussschicht an, die bei einer Ausgestaltung ein Metall oder eine Metalllegierung aufweist. Insbesondere kann das Metall oder die Metalllegierung Al, Ag oder Au aufweisen oder daraus bestehen.

Bei einer weiteren Ausgestaltung weist die Anschlussschicht ein transparentes leitfähiges Oxid auf. Transparente leitfähige Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO3, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs.

An einer Grenzfläche zur Anschlussschicht weist die p-Kontaktschicht erste Domänen mit einer Ga-face-Ausrichtung und zweite Domänen mit einer N-face-Ausrichtung auf. Die ersten Domänen und die zweiten Domänen unterscheiden sich in der Orientierung der Kristallstruktur.

Nitridverbindungshalbleiter bilden beim epitaktischen Wachsen in der Regel eine Wurtzit-Kristallstruktur aus, deren kristallographische c-Achse parallel zur Wachstumsrichtung verläuft. In Abhängigkeit von den Wachstumsparametern können dabei Domänen in der so genannten Ga-face-Ausrichtung, die der kristallografischen [0001]-Richtung entspricht, oder Domänen mit der so genannten N-face-Ausrichtung, die der kristallografischen [000-1]-Richtung entspricht, entstehen.

Nitridverbindungshalbleiter weisen pyroelektrische Eigenschaften auf, d. h. sie weisen auch ohne äußeres elektrisches Feld eine elektrische Polarisation auf. Die Orientierung dieses elektrischen Feldes ist für die Ga-face-Ausrichtung und die N-face-Ausrichtung entgegengesetzt. Aus diesem Grund weisen Domänen mit Ga-face-Ausrichtung und N-face-Ausrichtung verschiedene elektrische Eigenschaften auf. Die Erfindung macht sich die Erkenntnis zunutze, dass es vorteilhaft ist, wenn an der Grenzfläche zwischen der p-Kontaktschicht aus dem Nitridverbindungshalbleitermaterial und der angrenzenden Anschlussschicht aus einem Metall, einer Metalllegierung oder einem transparenten leitfähigen Oxid sowohl Domänen in der Ga-face-Ausrichtung als auch Domänen mit der N-face-Ausrichtung vorliegen.

Für die p-Dotierung des Nitridverbindungshalbleitermaterials sind die Ga-face-Domänen vorteilhaft. Dies beruht darauf, dass beim Wachstum des Halbleitermaterials, insbesondere mittels MOVPE, Wasserstoff in das Halbleitermaterial eingebaut wird, durch die der p-Dotierstoff, insbesondere Magnesium, teilweise passiviert wird. Der p-Dotierstoff wird beispielsweise durch eine Temperaturbehandlung aktiviert, bei der Wasserstoff aus dem Halbleitermaterial ausdiffundiert. Es hat sich herausgestellt, dass Wasserstoff besser aus den Ga-face-Domänen entweichen kann als aus den N-face-Domänen. Dies beruht darauf, dass Wasserstoff die Grenzfläche, an der das Kristallwachstum von der Ga-face-Standardwachstumsrichtung in eine N-face-Wachstumsrichtung übergeht, nicht oder nur schwer durchdringen kann. Somit ist die Aktivierung des p-Dotierstoffs einfacher, wenn die Oberfläche der p-Kontaktschicht Ga-face-Domänen aufweist.

Auf der anderen Seite haben die N-face-Domänen den Vorteil, dass sie einen Anschluss des Halbleitermaterials an eine Anschlussschicht aus einem Metall, einer Metalllegierung oder einem transparenten leitfähigen Oxid mit einem geringen oder sogar gar keinem Spannungsabfall ermöglichen. Dies beruht darauf, dass die N-face-Domänen in der Nähe der Grenzfläche zu den Ga-face-Domänen die Eigenschaften eines n-Typs-Halbleitermaterials aufweisen. Dieser Effekt beruht vermutlich darauf, dass in den N-face-Domänen Kristalldefekte auftreten, welche die Akzeptoren des nominell p-dotierten Halbleitermaterials überkompensieren. Dadurch, dass die N-face-Domänen an den Domänengrenzen n-Typ-Eigenschaften aufweisen, bildet sich zwischen dem p-dotierten Halbleitermaterial der p-Kontaktschicht und der angrenzenden Anschlussschicht ein lokaler Tunnelübergang aus. Dieser Effekt ermöglicht den Anschluss der Anschlussschicht nahezu ohne Spannungsabfall.

Andererseits wäre es aber nicht vorteilhaft, wenn die gesamte p-Kontaktschicht eine N-face-Ausrichtung aufweisen würde, weil aus den N-face-Domänen Wasserstoff nur schwer entweichen kann und somit eine Aktivierung des p-Dotierstoffs, insbesondere Magnesium, nur schwer möglich wäre. Erfindungsgemaß weist die p-Kontaktschicht an der Grenzfläche zur Anschlussschicht einen Flächenanteil von mindestens 10 % an Domänen mit Ga-face-Ausrichtung auf. Weiterhin beträgt der Flächenanteil der Domänen mit Ga-face Ausrichtung vorteilhaft höchstens 90%.

Bei einer bevorzugten Ausgestaltung weist die p-Kontaktschicht an der Grenzfläche zur Anschlussschicht einen Flächenanteil von mindestens 40 % und höchstens 70 % an Domänen mit Ga-face-Ausrichtung auf. Die übrigen mindestens 30 % und höchstens 60 % der Grenzfläche zwischen der Anschlussschicht und der p-Kontaktschicht weisen vorteilhaft Domänen mit N-face-Ausrichtung auf. Ein derartiges Verhältnis von Ga-face-Domänen zu N-face-Domänen ermöglicht einerseits einen vergleichsweise geringen oder gar keinen Spannungsabfall an der Grenzfläche zwischen der p-Kontaktschicht und der Anschlussschicht und vorteilhaft auch eine gute Aktivierung des p-Dotierstoffs, beispielsweise Magnesium. Der Spannungsabfall an der Grenzfläche zwischen der p-Kontaktschicht und der Anschlussschicht beträgt vorteilhaft weniger als 0,2 V, besonders bevorzugt weniger als 0,1 V.

Die ersten und/oder zweiten Domänen weisen beispielsweise eine laterale Ausdehnung von etwa 10 nm bis etwa 5 µm auf. Die N-face-Domänen weisen vorteilhaft eine laterale Ausdehnung von weniger als 1 *µ*m, bevorzugt von weniger als 100 nm und besonders bevorzugt von weniger als 10 nm auf. Eine derart geringe laterale Ausdehnung der N-face-Domänen ist vorteilhaft für die Aktivierung des p-Dotierstoffs.

Die Größe der Domänen und das Verhältnis der Ga-face-Domänen zu den N-face-Domänen können insbesondere über die Dotierstoffkonzentration und die Schichtdicke der p-Kontaktschicht eingestellt werden. Die p-Kontaktschicht weist eine Dotierstoffkonzentration zwischen einschließlich 5 * 10¹⁹ cm⁻³ und einschließlich 2 * 10²¹ cm⁻³ auf. Bei dem Dotierstoff handelt es sich vorzugsweise um Magnesium.

Es hat sich herausgestellt, dass sich N-face-Domänen insbesondere bei einer vergleichsweise hohen Dotierstoffkonzentration auf der Wachstumsoberfläche ausbilden. Bevorzugt wird daher die p-Kontaktschicht mit einer Dotierstoffkonzentration von mehr als 1 * 10²⁰ cm⁻³, insbesondere mit einer Dotierstoffkonzentration zwischen 1,5 * 10²⁰ cm⁻³ und 3 * 10²⁰ cm⁻³, hergestellt.

Die Dicke der p-Kontaktschicht beträgt vorteilhaft zwischen einschließlich 5 nm und einschließlich 200 nm, besonders bevorzugt 30 nm oder weniger.

Bei einer Ausgestaltung ist die aktive Schicht eine strahlungsemittierende Schicht und die Anschlussschicht an einer Strahlungsaustrittsseite des Bauelements angeordnet. In diesem Fall wird die Anschlussschicht vorteilhaft durch ein transparentes leitfähiges Oxid gebildet, sodass die von der aktiven Schicht emittierte Strahlung durch die Anschlussschicht aus dem Bauelement ausgekoppelt werden kann. Insbesondere kann die Anschlussschicht Indium-Zinn-Oxid (ITO) enthalten.

Dadurch, dass die p-Kontaktschicht an der Grenzfläche zur Anschlussschicht sowohl Ga-face-Domänen als auch N-face-Domänen aufweist, weist sie eine größere Rauheit auf als eine p-Kontaktschicht ohne Domänenstruktur. Diese Rauheit wirkt sich vorteilhaft auf die Strahlungsauskopplung aus dem optoelektronischen Bauelement aus. Insbesondere kann sich die Rauheit der p-Kontaktschicht in die darauf angeordnete Anschlussschicht fortsetzen, sodass vorteilhaft auch die Oberfläche der Anschlussschicht eine vergleichsweise hohe Rauheit aufweist. Die Anschlussschicht kann an ein Umgebungsmedium wie z. B. Luft angrenzen, wobei sich eine vergleichsweise hohe Rauheit der Oberfläche der Anschlussschicht vorteilhaft auf die Strahlungsauskopplung auswirkt, weil die Totalreflexion von Strahlung an der Grenzfläche zum Umgebungsmedium, insbesondere auch eine mehrfach Totalreflexion innerhalb des Halbleiterkörpers, vermindert wird.

Bei einer weiteren Ausgestaltung des optoelektronischen Bauelements ist die aktive Schicht eine strahlungsemittierende Schicht und die Strahlungsaustrittsseite des Bauelements liegt von der aktiven Schicht aus gesehen der Anschlussschicht gegenüber. In diesem Fall tritt die von der aktiven Schicht emittierte Strahlung an einer der p-Kontaktschicht und der Anschlussschicht gegenüberliegenden Seite aus dem optoelektronischen Bauelement aus. Bei dieser Ausgestaltung kann die Anschlussschicht insbesondere eine Spiegelschicht aus einem Metall oder einer Metalllegierung sein. Das Metall oder die Metalllegierung enthält vorzugsweise Silber, Aluminium oder Gold oder besteht daraus. Durch die Spiegelschicht wird die von der aktiven Schicht entgegengesetzt zur Strahlungsaustrittsseite emittierte Strahlung vorteilhaft in Richtung zur Strahlungsaustrittsseite reflektiert, um dort aus dem optoelektronischen Bauelement auszukoppeln.

Alternativ kann die Anschlussschicht auch ein transparentes leitfähiges Oxid wie beispielsweise ITO aufweisen, wobei der Anschlussschicht von der aktiven Schicht aus gesehen vorzugsweise eine Spiegelschicht nachfolgt. Die Spiegelschicht kann in diesem Fall eine Schicht aus einem Metall oder einer Metalllegierung sein. Besonders bevorzugt ist die Spiegelschicht bei dieser Ausgestaltung ein dielektrischer Spiegel. Der dielektrische Spiegel weist vorteilhaft eine Vielzahl von alternierenden Schichten aus zwei dielektrischen Materialien mit unterschiedlichem Brechungsindex, beispielsweise alternierende Schichten aus SiO₂ und SiN, auf. Mit einem dielektrischen Spiegel lässt sich vorteilhaft für eine vorgegebene Wellenlänge oder einen vorgegebenen Wellenlängenbereich eine höhere Reaktivität erzielen als mit einem metallischen Spiegel. Bei der Verwendung eines dielektrischen Spiegels erfolgt der elektrische Anschluss der p-Kontaktschicht über das transparente leitfähige Oxid der Anschlussschicht, das auch ohne eine nachfolgende Metallschicht für eine ausreichende Stromaufweitung sorgt.

Die Erfindung wird im Folgenden anhand von drei Ausführungsbeispielen näher erläutert.

Es zeigen:
- Figur 1: eine schematische Darstellung eines Querschnitts durch ein erstes Ausführungsbeispiel eines optoelektronischen Bauelements,
- Figur 2: eine schematische Darstellung eines Querschnitts durch ein zweites Ausführungsbeispiel eines optoelektronischen Bauelements und
- Figur 3: eine schematische Darstellung eines Querschnitts durch ein drittes Ausführungsbeispiel eines optoelektronischen Bauelements.

Gleiche oder gleich wirkende Bestandteile sind in den Figuren jeweils mit den gleichen Bezugszeichen versehen. Die dargestellten Bestandteile sowie die Größenverhältnisse der Bestandteile untereinander sind nicht als maßstabsgerecht anzusehen.

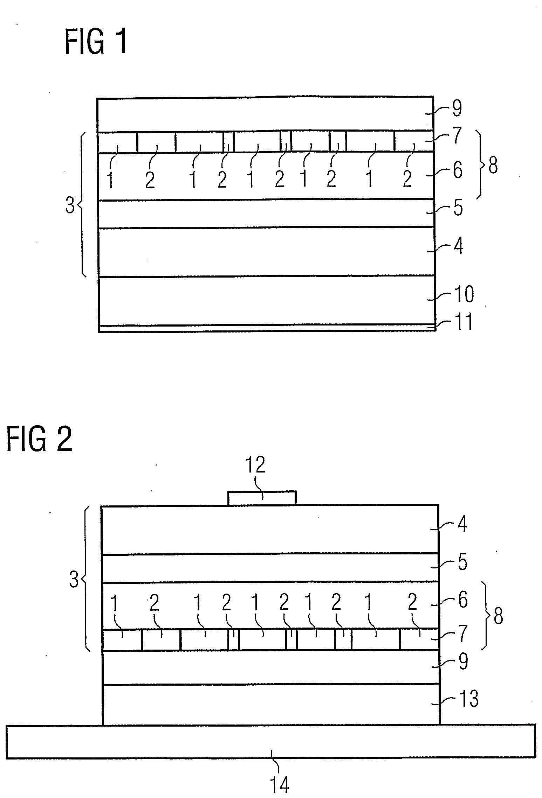

Das in Figur 1 dargestellte optoelektronische Halbleiterbauelement enthält eine Halbleiterschichtenfolge 3, die auf einem Nitridverbindungshalbleitermaterial basiert.

Die Halbleiterschichten 4, 5, 6, 7 der Halbleiterschichtenfolge 3 weisen also insbesondere InₓAl_{y}Ga_{1-x-y}N mit 0 ≤ x ≤ 1, 0 ≤ y ≤ 1 und x + y ≤ 1 auf.

Die Halbleiterschichtenfolge 3 ist beispielsweise epitaktisch auf ein Aufwachssubstrat 10 aufgewachsen. Das Aufwachssubstrat 10 ist zum Beispiel ein Saphir-Substrat oder ein GaN-Substrat.

Die Halbleiterschichtenfolge 3 enthält einen n-dotierten Bereich 4, einen p-dotierten Bereich 8 und eine zwischen dem n-dotierten Bereich 4 und dem p-dotierten Bereich 8 angeordnete aktive Schicht 5.

Der n-dotierte Bereich 4 und der p-dotierte Bereich 8 können jeweils eine oder mehrere Halbleiterschichten umfassen. In dem n-dotierten Bereich 4 und dem p-dotierten Bereich können weiterhin auch undotierte Schichten enthalten sein.

Die aktive Schicht 5 kann insbesondere eine strahlungsemittierende Schicht sein. Insbesondere kann die aktive Schicht 5 einen pn-Übergang oder vorzugsweise eine Einfach- oder Mehrfachquantentopfstruktur umfassen. Beispielsweise ist das Halbleiterbauelement eine LED oder ein Halbleiterlaser. Alternativ ist es auch möglich, dass die aktive Zone 5 eine strahlungsempfangende Schicht und das optoelektronische Halbleiterbauelement ein Detektor ist.

Der p-dotierte Bereich 8 enthält eine p-dotierte Schicht 6 und eine p-Kontaktschicht 7 aus InₓAl_{y}Ga_{1-x-y}N mit 0 ≤ x ≤ 1, 0 ≤ y ≤ 1 und x + y ≤ 1. Die p-Kontaktschicht 7 grenzt an eine Anschlussschicht 9 aus einem Metall, einer Metalllegierung oder einem transparenten leitfähigen Oxid an.

Die Anschlussschicht 9 dient zur Herstellung eines elektrischen Kontakts, um einen elektrischen Strom in die Halbleiterschichtenfolge 3 zu leiten. Ein weiterer elektrischer Kontakt 11 kann beispielsweise an der Rückseite des Substrats 10 angeordnet sein, wenn ein elektrisch leitfähiges Substrat verwendet wird.

Die p-Kontaktschicht 7 weist verschiedene Domänen 1, 2 mit unterschiedlicher Ausrichtung der Kristallstruktur des Nitridverbindungshalbleitermaterials auf. Insbesondere enthält die p-Kontaktschicht 7 an der Grenzfläche zur Anschlussschicht 9 erste Domänen 1 mit einer Ga-face-Ausrichtung und zweite Domänen 2 mit einer N-face-Ausrichtung. Die Ga-face-Domänen 1 sind in der [0001]-Kristallrichtung und die N-face-Domänen 2 in der [000-1]-Kristallrichtung des hexagonalen Kristallgitters des Nitridverbindungshalbleitermaterials ausgerichtet. Aufgrund der unterschiedlichen Ausrichtungen der Bindungen zwischen dem Gruppe III-Material (Ga, In oder Al) und den N-Atomen in den Ga-face-Domänen 1 und den N-face-Domänen 2 unterscheiden sich die Domänen 1, 2 in ihren mechanischen und elektrischen Eigenschaften.

Es ist vorteilhaft, wenn die p-Kontaktschicht 7 sowohl Ga-face-Domänen 1 als auch N-face-Domänen 2 aufweist.

Die Aktivierung des p-Dotierstoffs, vorzugsweise Magnesium, eines Nitridverbindungshalbleitermaterials erfolgt in der Regel durch eine Temperaturbehandlung, bei der Wasserstoff aus dem Halbleitermaterial austritt. Es hat sich herausgestellt, dass Wasserstoff besser aus den Ga-face-Domänen 1 als aus den N-face-Domänen 2 entweichen kann. Daher ist es vorteilhaft, wenn zumindest Teilbereiche der p-Kontaktschicht 7 erste Domänen 1 in der Ga-face-Ausrichtung aufweisen.

Die N-face-Domänen 2 ermöglichen vorteilhaft den elektrischen Anschluss der p-Kontaktschicht 7 an die Anschlussschicht 9 ohne signifikanten Spannungsabfall. Dies beruht darauf, dass die Domänen 2 mit N-face-Ausrichtung an der Grenzfläche zur Anschlussschicht 9 trotz der nominellen p-Dotierung n-Typ-Eigenschaften aufweisen. Es wird vermutet, dass sich in den N-face-Domänen Defekte in der Kristallschicht ausbilden, die zur Überkompensation der Akzeptoren führen und somit für die n-Typ-Eigenschaft der N-face-Domänen 2 verantwortlich sind.

Die N-face-Domänen 2 bilden an der Grenzfläche zur Anschlussschicht 9 aufgrund ihrer n-Typ-Eigenschaft einen Tunnelübergang aus, durch den die p-Kontaktschicht 7 ohne signifikanten Spannungsabfall an die Anschlussschicht 9 elektrisch angeschlossen ist. Vorzugsweise beträgt der Spannungsabfall an der Grenzfläche zwischen der p-Kontaktschicht 7 und der Anschlussschicht 9 weniger als 0,2 V, besonders bevorzugt weniger als 0,1 V.

Der beim elektrischen Anschluss einer herkömmlichen p-dotierten Nitridverbindungshalbleiterschicht an eine Anschlussschicht, beispielsweise eine Schicht aus einem transparenten leitfähigen Oxid, typischerweise auftretende Spannungsabfall von mehr als 0,2 V wird durch die N-face-Domänen in der p-Kontaktschicht 7 vermindert oder sogar ganz vermieden.

Die Anschlussschicht 9 ist vorzugsweise eine Schicht aus einem transparenten leitfähigen Oxid, beispielsweise ITO oder ZnO. Eine Anschlussschicht 9 aus einem transparenten leitfähigen Oxid ist insbesondere vorteilhaft, wenn das optoelektronische Halbleiterbauelement eine LED ist, bei der die Strahlungsauskopplung durch die Anschlussschicht 9 erfolgt. Die Anschlussschicht 9 kann in diesem Fall vorteilhaft auf die gesamte p-Kontaktschicht 7 aufgebracht werden, wodurch eine gute Stromaufweitung ohne wesentliche Absorptionsverluste in der Anschlussschicht 9 erfolgt.

Alternativ kann es sich bei .der Anschlussschicht 9 um eine Schicht aus einem Metall oder einer Metalllegierung handeln, die in diesem Fall vorzugsweise nur bereichsweise auf die p-Kontaktschicht 7 aufgebracht wird. Im Fall einer Anschlussschicht 9 aus einem Metall oder einer Metalllegierung kann diese beispielsweise Aluminium aufweisen oder daraus bestehen.

Die p-Kontaktschicht 7 weist an der Grenzfläche zur Anschlussschicht 9 vorteilhaft einen Flächenanteil von mindestens 10 % und höchstens 90 %, besonders bevorzugt mindestens 40 % und höchstens 70 %, an Domänen mit Ga-face-Ausrichtung auf.

Die ersten und zweiten Domänen 1, 2 müssen sich nicht notwendigerweise, wie in Figur 1 dargestellt, durch die gesamte Dicke der p-Kontaktschicht 7 erstrecken, sondern können alternativ auch nur im Bereich der Grenzfläche zur Anschlussschicht 9 ausgebildet sein. Somit kann sich sowohl die vertikale als auch die laterale Ausdehnung der Domänen voneinander unterscheiden. Insbesondere muss die laterale Ausdehnung der ersten und zweiten Domänen 1, 2 nicht über die Schichtdicke der p-Kontaktschicht 7 konstant sein, sondern kann auch variieren. Beispielsweise können die Domänen 1, 2 die Form von Pyramidenstümpfen aufweisen.

Die Ausbildung der Ga-face-Domänen 1 und der N-face-Domänen 2 hängt insbesondere von der Dotierstoffkonzentration und der Schichtdicke der p-Kontaktschicht 7 ab.

Damit sich sowohl Ga-face-Domänen 1 als auch N-face-Domänen 2 in der p-Kontaktschicht 7 ausbilden, wird die Dicke der p-Kontaktschicht vorteilhaft zwischen 5 nm und 200 nm und die Dotierstoffkonzentration zwischen einschließlich 5 * 10¹⁹ cm⁻³ und 2 * 10²¹ cm⁻³ eingestellt. Bevorzugt weist die p-Kontaktschicht 7 eine Dicke von 20 nm oder weniger auf. Die Dotierstoffkonzentration beträgt bevorzugt mehr als 1 * 10²⁰ cm⁻³, beispielsweise zwischen 1,5 * 10²⁰ cm⁻³ und 3 * 10²⁰ cm⁻³.

Die laterale Ausdehnung der ersten Domänen 1 und/oder zweiten Domänen 2 beträgt an der Grenzfläche zwischen der p-Kontaktschicht 7 und der Anschlussschicht 9 beispielsweise zwischen 10 nm und 5 *µ*m.

Besonders vorteilhaft ist es, wenn die laterale Ausdehnung der N-face-Domänen 2 an der Grenzfläche zur Anschlussschicht 9 weniger als 1 *µ*m, bevorzugt weniger als 100 nm und besonders bevorzugt weniger als 10 nm beträgt. Auf diese Weise wird erreicht, dass zwischen den N-face-Domänen 2 genügend viele und große Ga-face-Domänen 1 angeordnet sind, durch die Wasserstoff beim Aktivieren des p-Dotierstoffs in der p-Kontaktschicht 7 entweichen kann.

Dadurch, dass in der p-Kontaktschicht 7 erste Domänen 1 und zweite Domänen 2 ausgebildet sind, weist die p-Kontaktschicht 7 eine größere Rauheit auf als herkömmliche p-Kontaktschichten aus einem Nitridverbindungshalbleiter. Diese erhöhte Rauheit kann sich über die Grenzfläche zur Anschlussschicht 9 bis zur Oberfläche der Anschlussschicht 9 fortpflanzen, was sich vorteilhaft auf die Strahlungsauskopplung aus dem optoelektronischen Halbleiterbauelement auswirkt.

Bei dem in Figur 2 dargestellten Ausführungsbeispiel eines optoelektronischen Halbleiterbauelements handelt es sich um eine so genannte Dünnfilm-LED, bei der die Halbleiterschichtenfolge 3 von ihrem ursprünglichen Aufwachssubstrat abgelöst ist. Das ursprüngliche Aufwachssubstrat ist von dem n-dotierten Bereich 4 abgelöst, der bei diesem Ausführungsbeispiel an der Strahlungsaustrittsseite des optoelektronischen Bauelements angeordnet ist. Auf der dem ursprünglichen Aufwachssubstrat gegenüberliegenden Seite ist das Halbleiterbauelement beispielsweise mit einer Lotschicht 13 auf einen Trägerkörper 14 aufgebracht. Von der aktiven Schicht 5 aus gesehen ist also der p-dotierte Bereich 8 mit der p-Kontaktschicht 7 dem Trägerkörper 14 zugewandt. Der Trägerkörper 14 kann beispielsweise Germanium oder eine Keramik aufweisen.

Wie bei dem zuvor beschriebenen Ausführungsbeispiel enthält die p-Kontaktschicht 7 erste Domänen 1 in Ga-face-Ausrichtung und zweite Domänen 2 in N-face-Ausrichtung. Die p-Kontaktschicht 7 mit den ersten und den zweiten Domänen 1, 2 grenzt an die Anschlussschicht 9 an, die vorteilhaft ein Metall oder eine Metalllegierung enthält. Zur Herstellung eines zweiten elektrischen Anschlusses kann auf den n-dotierten Bereich 4 eine Kontaktschicht 12 aufgebracht sein.

Die vorteilhaften Ausgestaltungen der Domänen 1, 2 in der p-Kontaktschicht 7 und die damit verbundenen Vorteile für den elektrischen Anschluss an die Anschlussschicht 9 entsprechen dem zuvor beschriebenen Ausführungsbeispiel.

Die Anschlussschicht 9 ist vorzugsweise eine reflektierende Schicht, um die von der aktiven Zone 5 in Richtung des Trägerkörpers 14 emittierte Strahlung zu der gegenüberliegenden Strahlungsaustrittsfläche an der Oberfläche des n-dotierten Bereichs 4 zu reflektieren. Die reflektierende Anschlussschicht 9 kann insbesondere Aluminium, Silber oder Gold aufweisen oder daraus bestehen. Zwischen der reflektierenden Anschlussschicht 9 und der Lotschicht 13, mit der das Halbleiterbauelement mit dem Trägerkörper 14 verbunden ist, können eine oder mehrere weitere Schichten angeordnet sein (nicht dargestellt). Insbesondere kann es sich dabei um eine Haftschicht, eine Benetzungsschicht und/oder eine Barriereschicht, die eine Diffusion des Materials der Lotschicht 13 in die reflektierende Anschlussschicht 9 verhindern soll, handeln.

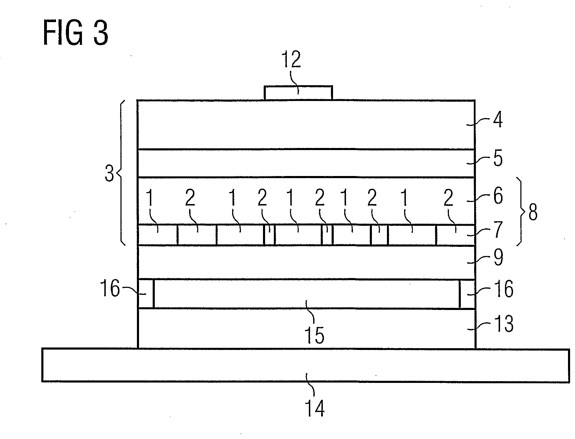

Das in Figur 3 dargestellte weitere Ausführungsbeispiel eines optoelektronischen Halbleiterbauelements unterscheidet sich von dem in Figur 2 dargestellten Bauelement dadurch, dass die Anschlussschicht 9 keine Schicht aus einem Metall oder einer Metalllegierung, sondern eine Schicht aus einem transparenten leitfähigen Oxid ist. Insbesondere kann die Anschlussschicht 9, die an die p-Kontaktschicht 7 angrenzt, eine Schicht aus Indium-Zinn-Oxid (ITO) sein. Von der aktiven Schicht 5 aus gesehen folgt der transparenten Anschlussschicht 9 eine Spiegelschicht 15 nach.

Die Spiegelschicht 15 kann insbesondere ein dielektrischer Spiegel sein. Der dielektrische Spiegel 15 kann beispielsweise eine Vielzahl von alternierenden SiO₂-Schichten und SiN-Schichten enthalten. Ein dielektrischer Spiegel hat gegenüber metallischen Spiegeln den Vorteil, dass sich für eine vorgegebene Wellenlänge oder einen vorgegebenen Wellenlängenbereich in der Regel eine höhere Reflexion erzielen lässt als mit der metallischen Spiegelschicht. Im Fall eines dielektrischen Spiegels 15 kann die Anschlussschicht 9 beispielsweise über eine oder mehrere elektrisch leitfähige Verbindungen 16 mit der Lotschicht 13 verbunden sein.

Im Übrigen entspricht das Ausführungsbeispiel der Figur 3 hinsichtlich seiner Funktionsweise und den weiteren vorteilhaften Ausgestaltungen dem in Figur 2 dargestellten Ausführungsbeispiel.

Die Erfindung ist nicht durch die Beschreibung anhand der Ausführungsbeispiele beschränkt.

## Patentansprüche

1. Optoelektronisches Halbleiterbauelement mit einer auf einem Nitridverbindungshalbleiter basierenden Halbleiterschichtenfolge (3), die einen n-dotierten Bereich (4), einen p-dotierten Bereich (8) und eine zwischen dem n-dotierten Bereich (4) und dem p-dotierten Bereich (8) angeordnete aktive Zone (5) enthält, wobei der p-dotierte Bereich (8) eine p-Kontaktschicht (7) aus InₓAl_{y}Ga_{1-x-y}N mit 0 ≤ x ≤ 1, 0 ≤ y ≤ 1 und x + y ≤ 1 umfasst, die an eine Anschlussschicht (9) aus einem Metall, einer Metalllegierung oder einem transparenten leitfähigen Oxid angrenzt, wobei
- die p-Kontaktschicht (7) an einer Grenzfläche zur Anschlussschicht (9) erste Domänen (1) mit einer Ga-face-Ausrichtung und zweite Domänen (2) mit einer N-face-Ausrichtung aufweist,
- die p-Kontaktschicht (7) eine Dotierstoffkonzentration zwischen einschließlich 5 * 10¹⁹ cm⁻³ und einschließlich 2 * 10²¹ cm⁻³ aufweist, **dadurch gekennzeichnet, daß**
- die p-Kontaktschicht (7) eine Dicke zwischen einschließlich 5 nm und einschließlich 200 nm aufweist, und
- die p-Kontaktschicht (7) an der Grenzfläche zur Anschlussschicht (9) einen Flächenanteil von mindestens 10% und höchstens 90% an Domänen (1) mit Ga-face-Ausrichtung aufweist.

2. Optoelektronisches Halbleiterbauelement nach Anspruch 1, wobei die p-Kontaktschicht (7) an der Grenzfläche zur Anschlussschicht (9) einen Flächenanteil von mindestens 40% und höchstens 70% an Domänen (1) mit Ga-face-Ausrichtung aufweist.

3. Optoelektronisches Halbleiterbauelement nach einem der vorhergehenden Ansprüche,
wobei die ersten Domänen (1) und/oder die zweiten Domänen (2) jeweils eine laterale Ausdehnung von 10 nm bis 5 µm aufweisen.

4. Optoelektronisches Halbleiterbauelement nach einem der vorhergehenden Ansprüche,
wobei die zweiten Domänen (2) eine laterale Ausdehnung von weniger als 1 µm aufweisen.

5. Optoelektronisches Halbleiterbauelement nach einem der vorhergehenden Ansprüche,
wobei die p-Kontaktschicht (7) eine Dotierstoffkonzentration von mehr als 1 x 10²⁰ cm⁻³ aufweist.

6. Optoelektronisches Halbleiterbauelement nach einem der vorhergehenden Ansprüche,
wobei die die p-Kontaktschicht (7) eine Dicke von 30 nm oder weniger aufweist.

7. Optoelektronisches Halbleiterbauelement nach einem der vorhergehenden Ansprüche,
wobei die aktive Zone (5) eine strahlungsemittierende Schicht ist und die Anschlussschicht (9) an einer Strahlungsaustrittsseite des Bauelements angeordnet ist.

8. Optoelektronisches Halbleiterbauelement nach Anspruch 7, wobei die Anschlussschicht (9) ein transparentes leitfähiges Oxid aufweist.

9. Optoelektronisches Halbleiterbauelement nach einem der Ansprüche 1 bis 6,
wobei die aktive Zone (5) eine strahlungsemittierende Schicht ist und eine Strahlungsaustrittsseite des Bauelements von der strahlungsemittierenden Schicht (5) aus gesehen der Anschlussschicht (9) gegenüberliegt.

10. Optoelektronisches Halbleiterbauelement nach Anspruch 9, wobei die Anschlussschicht (9) eine Spiegelschicht aus einem Metall oder einer Metalllegierung ist.

11. Optoelektronisches Halbleiterbauelement nach Anspruch 9, wobei die Anschlussschicht (9) ein transparentes leitfähiges Oxid aufweist.

12. Optoelektronisches Halbleiterbauelement nach Anspruch 11,
wobei der Anschlussschicht (9) von der aktiven Schicht (5) aus gesehen eine Spiegelschicht (15) nachfolgt.

13. Optoelektronisches Halbleiterbauelement nach Anspruch 12,
wobei die Spiegelschicht (15) ein dielektrischer Spiegel ist.

## Claims

1. An optoelectronic semiconductor component comprising a semiconductor layer sequence (3) based on a nitride compound semiconductor and containing an n-doped region (4), a p-doped region (8) and an active zone (5) arranged between the n-doped region (4) and the p-doped region (8), wherein the p-doped region (8) comprises a p-type contact layer (7) composed of InₓAl_{y}Ga_{1-x-y}N where 0 ≤ x ≤ 1, 0 ≤ y ≤ 1 and x + y ≤ 1, which adjoins a connection layer (9) composed of a metal, a metal alloy or a transparent conductive oxide, wherein
- the p-type contact layer (7) has first domains (1) having a Ga-face orientation and second domains (2) having an N-face orientation at an interface with the connection layer (9),
- the p-type contact layer (7) has a dopant concentration of between 5 * 10¹⁹ cm⁻³ and 2 * 10²¹ cm⁻³ inclusive,
- the p-type contact layer (7) has a thickness of between 5 nm and 200 nm inclusive, and
- the p-type contact layer (7) has an area proportion of at least 10% and at most 90% of domains (1) having Ga-face orientation at the interface with the connection layer (9).

2. The optoelectronic semiconductor component according to claim 1,
wherein the p-type contact layer (7) has an area proportion of at least 40% and at most 70% of domains (1) having Ga-face orientation at the interface with the connection layer (9).

3. The optoelectronic semiconductor component according to any of the preceding claims,
wherein the first domains (1) and/or the second domains (2) each have a lateral extent of 10 nm to 5 µm.

4. The optoelectronic semiconductor component according to any of the preceding claims,
wherein the second domains (2) have a lateral extent of less than 1 µm.

5. The optoelectronic semiconductor component according to any of the preceding claims,
wherein the p-type contact layer (7) has a dopant concentration of more than 1 * 10²⁰ cm⁻³.

6. The optoelectronic semiconductor component according to any of the preceding claims,
wherein the p-type contact layer (7) has a thickness of 30 nm or less.

7. The optoelectronic semiconductor component according to any of the preceding claims,
wherein the active zone (5) is a radiation-emitting layer and the connection layer (9) is arranged at a radiation exit side of the component.

8. The optoelectronic semiconductor component according to claim 7,
wherein the connection layer (9) comprises a transparent conductive oxide.

9. The optoelectronic semiconductor component according to any of claims 1 to 6,
wherein the active zone (5) is a radiation-emitting layer and a radiation exit side of the component lies opposite the connection layer (9) as seen from the radiation-emitting layer (5).

10. The optoelectronic semiconductor component according to claim 9,
wherein the connection layer (9) is a mirror layer composed of a metal or a metal alloy.

11. The optoelectronic semiconductor component according to claim 9,
wherein the connection layer (9) comprises a transparent conductive oxide.

12. The optoelectronic semiconductor component according to claim 11,
wherein the connection layer (9) is succeeded by a mirror layer (15) as seen from the active layer (5).

13. The optoelectronic semiconductor component according to claim 12,
wherein the mirror layer (15) is a dielectric mirror.

## Revendications

1. Dispositif semi-conducteur optoélectronique comprenant une succession de couches semi-conductrices (3) sur la base d'un semi-conducteur à composé de nitrure, laquelle contient une zone (4) dopée n, une zone (8) dopée p et une zone active (5) disposée entre la zone (4) dopée n et la zone (8) dopée p, la zone (8) dopée p comprenant une couche de contact p (7) constituée de InₓAl_{y}Ga_{1-x-y}N, où 0 ≤ x ≤ 1, 0 ≤ y ≤ 1 et x + y ≤ 1, laquelle est adjacente à une couche de connexion (9) constituée d'un métal, d'un alliage de métal ou d'un oxyde conducteur transparent,
- la couche de contact p (7) présentant sur un interface à la couche de connexion (9) des premiers domaines (1) ayant une orientation de face Ga et des deuxièmes domaines (2) ayant une orientation de face N,
- la couche de contact p (7) présentant une concentration de dopant comprise entre, y compris, 5 * 10¹⁹ cm⁻³ et, y compris, 2 * 10²¹ cm⁻³,
**caractérisé en ce que**
- la couche de contact p (7) présente une épaisseur comprise entre, y compris, 5 nm et, y compris, 200 nm, et
- **en ce que** la couche de contact p (7) présente sur l' interface à la couche de connexion (9) un pourcentage surfacique d'au moins 10% et de maximum 90% aux domaines (1) à orientation de face Ga.

2. Dispositif semi-conducteur optoélectronique selon la revendication 1,
la couche de contact p (7) présentant sur l'interface à la couche de connexion (9) un pourcentage surfacique d'au moins 40% et de maximum 70% aux domaines (1) à orientation de face Ga.

3. Dispositif semi-conducteur optoélectronique selon l'une quelconque des revendications précédentes,
les premiers domaines (1) et/ou les deuxièmes domaines (2) présentant respectivement une étendue latérale de 10 nm à 5 µm.

4. Dispositif semi-conducteur optoélectronique selon l'une quelconque des revendications précédentes,
les deuxièmes domaines (2) présentant une étendue latérale de moins de 1 µm.

5. Dispositif semi-conducteur optoélectronique selon l'une quelconque des revendications précédentes,
la couche de contact p (7) présentant une concentration de dopant de plus de 1 × 10²⁰ cm⁻³.

6. Dispositif semi-conducteur optoélectronique selon l'une quelconque des revendications précédentes,
la couche de contact p (7) présentant une épaisseur de 30 nm ou moins.

7. Dispositif semi-conducteur optoélectronique selon l'une quelconque des revendications précédentes,
la zone active (5) étant une couche émettrice de rayonnement et la couche de connexion (9) étant disposée sur un côté de sortie de rayonnement du dispositif.

8. Dispositif semi-conducteur optoélectronique selon la revendication 7,
la couche de connexion (9) présentant un oxyde conducteur transparent.

9. Dispositif semi-conducteur optoélectronique selon l'une quelconque des revendications 1 à 6,
la zone active (5) étant une couche émettrice de rayonnement, et un côté de sortie de rayonnement du dispositif, en vue depuis la couche (5) émettrice de rayonnement, étant disposé de manière opposée à la couche de connexion (9).

10. Dispositif semi-conducteur optoélectronique selon la revendication 9,
la couche de connexion (9) étant une couche réfléchissante constituée d'un métal ou d'un alliage de métal.

11. Dispositif semi-conducteur optoélectronique selon la revendication 9,
la couche de connexion (9) présentant un oxyde conducteur transparent.

12. Dispositif semi-conducteur optoélectronique selon la revendication 11,
la couche de connexion (9), en vue depuis la couche active (5), succédant à une couche réfléchissante (15).

13. Dispositif semi-conducteur optoélectronique selon la revendication 12,
la couche réfléchissante (15) étant un miroir diélectrique.
